# EUROPÄISCHE PATENTANMELDUNG

(11) **EP 1 227 458 A2**
(43) Veröffentlichungstag der Anmeldung: **31.07.2002**
(21) Anmeldenummer: 02000671.4
(22) Anmeldetag: 11.01.2002
(51) Int. Cl.: G09F 9/33, H01L 33/00, F21V 5/04, F21V 9/00

(54) **Anzeige- und/oder Signalsiervorrichtung**

(30) Priorität: 11.01.2001 AT 382001
(71) Anmelder: Dr. techn. Josef Zelisko, Fabrik für Elektrotechnik und Maschinenbau Gesellschaft m.b.H., 2340 Mödling (AT)
(72) Erfinder: Otto, Alexander, Dipl.-Ing., A 2102 Bisamberg (AT); Bendekovics, Günter, Ing., A 2560 Berndorf (AT)
(74) Vertreter: Secklehner, Günter, Dr.

(57) **Zusammenfassung**

Die Erfindung betrifft eine Anzeige- und/oder Signalisiervorrichtung für lichtoptische Informationen mit auf einer Trägerplatte oder Gehäuseteil angeordneten Lichtquellen (3), insbesondere LED's (28), und mit Mittel zu deren Energieversorgung und mit einer den Lichtquellen (3) vorgesetzten Linsenanordnung (18). Die Linsenanordnung (18) bildet ein einstükkiges, flächiges Anzeigefeld (17) mit einer Mehrzahl von über Wandbereiche (20) verbundenen Linsenkörper (19) aus und auf einer den Lichtquellen (3) zugewandten Oberfläche (34) ist eine durch Lichteintrittsflächen (39) unterbrochene Lichtabsorptionsschicht (52) angeordnet.

## Beschreibung

Die Erfindung betrifft eine Anzeige- und/oder Signalisiervorrichtung, wie im Oberbegriff des Anspruches 1 beschrieben.

Aus der FR 2 694 815 A1 ist eine Vorrichtung zur Abgabe von Informationen in Form von Lichtsignalen bekannt. Bei dieser sind weiters Bewegungssensoren zur Ermittlung einer vor dieser Vorrichtung anwesenden Person vorgesehen, womit es möglich ist, die Lichtsignale nur bei Bedarf abzugeben, womit Energie gespart und die Bereitschaftszeit der Vorrichtung erhöht wird. Eine derartige Vorrichtung weist jedoch keine besonderen optischen Mittel auf, um die Informationen auch noch bei größerer Distanz des Betrachters eindeutig erkennen zu können.

Weiters ist aus der EP 0 403 764 B 1 eine beleuchtete Anzeigeeinheit, insbesondere Hausnummer, Verkaufsschild, Werbeträger etc., bekannt, die aus einer Lichtleitplatte mit auf dieser angeordneten und beleuchteten Anzeigesymbolen besteht, wobei die Lichtleitplatte bevorzugt fluoreszierende Partikel enthält. Als Lichtquellen sind insbesondere mehrere Leuchtdioden vorgesehen, die in einer Lichtleitleiste angeordnet sind und die von den Leuchtdioden ausgesandten Lichtstrahlen in die Lichtleitplatte über zumindest eine seitliche Begrenzungskante eingeleitet werden und damit die auf der Lichtleitplatte aufgebrachten Zeichen, Zahlen, Grafiken, die von einem Betrachter aus gesehen an einer der jeweils hinteren Flächen der Lichtleitplatte aufgeklebt oder aufgedampft sind, beleuchtet und dem Betrachter sichtbar gemacht werden.

Aus der EP 0 453 932 A2 - von derselben Anmelderin - ist eine Signalanordnung mit einer Linsenanordnung bekannt. Diese Linsenanordnung besteht aus einer über eine Austrittsfläche derselben verteilt angeordneten Mehrzahl von Plankonvexlinsen, deren konvexe Krümmungslinsen Eintrittsflächen für Lichtstrahlen ausbilden und einem Betrachter zugewandt eine Vielzahl von Planflächen aufweist, wobei jeder Planfläche jeweils eine Plankonvexlinse zugeordnet ist. Vertiefte Bereiche zwischen den Planflächen sind mit einer lichtundurchlässigen Beschichtung zur Verhinderung eines Strahlenduchlasses von Fremdlichtquellen, z.B. Sonnenstrahlen, versehen. Eine derartige Linsenanordnung ist für eine zentrale Lichtquelle, von der ein Strahlenbündel über eine Reflektoranordnung der Linsenanordnung zugeführt wird, zur Verhinderung von Phantombildern geeignet, wobei allerdings bei einer Anordnung einer Vielzahl von Lichtquellen mit direkter Abgabe der Lichtstrahlen eine derartige Linsenanordnung ungeeignet ist.

Es ist aber auch aus der DE 199 22 361 A1 ein LED-Modul für Signaleinrichtungen bekannt, bei dem auf einer Platine LED's regelmäßig angeordnet sind und weiters in einer Grundplatte eine der LED-Anordnung entsprechende regelmäßige Anordnung von lichtbündelnden optischen Einrichtungen in Form von Linsen oder in die Grundplatte integrierte optische Kanäle vorgesehen sind. Eine derartige Ausbildung weist jedoch keinerlei Maßnahmen zur Verbesserung der Erkennbarkeit der Informationen bei ungünstigen Lichtverhältnissen, z. B. Blendwirkungen und Reflexionen, hervorgerufen durch Fremdlicht, auf.

Aufgabe der Erfindung ist es, eine Anzeige- und/oder Signalisiervorrichtung zu schaffen, bei der unabhängig von den diese umgebenden Lichtverhältnissen ein einwandfreies Erkennen der Informationen erreicht wird.

Diese Aufgabe der Erfindung wird durch die im Kennzeichenteil des Anspruches 1 wiedergegebenen Merkmale erreicht. Der überraschende Vorteil dabei ist, daß ausgehend von den eher punktförmigen Lichtquellen auf der Betrachtungsseite eines Anzeigefeldes eine relativ große und eine gleichmäßige Leuchtstärke aufweisende und durch die Lichtabsorptionsschicht von jeglichen Reflexionsstrahlen freie Leuchtfläche bewirkt wird, wodurch bereits bei einer geringen Anzahl von Lichtquellen wirkungsvolle lichtoptische Anzeigen erreicht werden, die auch mit hoher Sicherheit erkennbar sind.

Möglich ist dabei auch eine Ausführung wie im Anspruch 2 beschrieben, weil durch die Gestaltung der Linsenkörper mit den Lichtleitfortsätzen eine Minimierung des Materialaufwandes für die Linsenanordnung erreicht wird.

Möglich ist aber auch eine Ausbildung nach Anspruch 3, wodurch eine parallele Ausrichtung der austretenden Lichtstrahlen zur Erzielung einer hohen Leuchtdichte erreicht wird.

Es ist aber auch eine Ausbildung nach Anspruch 4 vorteilhaft, weil dadurch eine unterschiedliche räumliche Gestaltung eines Lichtstrahlenbündels ermöglicht wird.

Gemäß den vorteilhaften Weiterbildungen, wie in den Ansprüchen 5 und 6 beschrieben, wird ein Streuwinkel des von der Lichtquelle ausgehenden Strahlenbündels begrenzt.

Durch die im Anspruch 7 beschriebene vorteilhafte Weiterbildung kommt es zu einer überschneidungsfreien Ausbildung der Lichtflächen auf dem Anzeigefeld.

Durch die bevorzugten Weiterbildungen, wie in den Ansprüchen 8 bis 10 beschrieben, kommt es zu einer Optimierung der Linsenanordnung, wodurch die Informationen in klarer und für den Betrachter deutlicher Form am Anzeigefeld wiedergegeben werden können.

Von Vorteil sind aber auch Ausbildungen nach den Ansprüchen 11 bis 15, wodurch von Fremdlichtquellen auftreffende Lichtstrahlen zur Unterbindung jeglicher Reflexionen absorbiert werden, um einerseits einen Phantombildeffekt zu vermeiden und andererseits keinen Störungseinfluß auf das zur Bildung der Informationen am Anzeigefeld wirkende Nutzlicht zu bewirken, wodurch auch unter ungünstigsten Fremdlichtverhältnissen die am Anzeigefeld erscheinenden Informationen für den Betrachter klar und deutlich ersichtlich sind. Die Aufbringung der Lichtabsorptionsschichte kann vorteilhaft auf unterschiedliche Weise z.B. durch Streichen, Sprühen, Laserbeschichten etc., erfolgen, wodurch die Fertigung einer derartigen Linsenanordnung sehr wirtschaftlich und in für eine Serienherstellung geeigneter Weise erfolgen kann.

Gemäß den vorteilhaften Ausbildungen, wie in den Ansprüchen 16 und 17 beschrieben, werden Lichtverluste wirkungsvoll vermieden.

Eine bevorzugte Weiterbildung, wie im Anspruch 18 beschrieben, ermöglicht eine bedarfsgerechte Anpassung der Lichtverteilfläche an beliebige Gestaltungen einzelner voneinander unterschiedlicher Informationsblocks des Anzeigefeldes.

Gemäß einer weiteren vorteilhaften Ausbildung, wie im Anspruch 19 beschrieben, werden kontinuierlich verlaufende Oberflächenbereiche erreicht, wodurch einerseits auftreffende Fremdlichtstrahlen, sofern sie nicht durch die Absorptionsschichte absorbiert werden und Reflexionsstrahlen ergeben könnten, aus dem Betrachtungsbereich abgelenkt werden und weiters bewirkt eine dadurch erzielbare Oberfläche, den Verschmutzungsgrad gering zu halten und eine Reinhaltung der Oberfläche zu erleichtern.

Gemäß der vorteilhaften Weiterbildung, wie in den Ansprüchen 20 bis 23 beschrieben, wird eine kompakte Bauform mit einer von Umwelteinflüssen geschützten Anordnung der Bauelemente erreicht und damit die Anzeige- und/oder Signalisiervorrichtung für den Einsatz unter erschwerten Umgebungsbedingungen geeignet.

Eine Ausbildung gemäß Anspruch 24 ermöglicht einen sehr einfachen Aufbau der Vorrichtung sowie eine Vereinfachung bei der Bestückung des Trägerelementes mit den LED's.

Die vorteilhafte Weiterbildung gemäß Anspruch 25 ermöglicht einen vielseitigen Einsatz der Vorrichtung, da einzelnen Farben in der Signaltechnik ganz bestimmte Bedeutungen zugeordnet sind.

Es sind auch Ausbildungen gemäß den Ansprüchen 26 bis 28 vorteilhaft, wodurch eine sehr variable und wirkungsvolle Gestaltung der lichtoptischen Informationen erreicht wird, wodurch eine sehr hohe Wirkung auf den Betrachter ausgeübt wird.

Schließlich ist auch die Ausbildung nach Anspruch 29 vorteilhaft, weil dadurch ein modulartiger Aufbau erreicht wird.

Zum besseren Verständnis der Erfindung wird diese anhand der in den nachstehenden Figuren gezeigten Ausführungsbeispiele näher erläutert.

Es zeigen:
- Fig. 1: eine erfindungsgemäße Anzeige- und/oder Signalisiervorrichtung in schematischer Darstellung;
- Fig. 2: eine Anzeigeeinheit der erfindungsgemäßen Anzeige- und/oder Signalisiervorrichtung, geschnitten gemäß den Linien II-II in Fig. 1;
- Fig. 3: einen Teilbereich mit einer Linsenanordnung der erfindungsgemäßen Anzeige-und/oder Signalisiervorrichtung, geschnitten;
- Fig. 4: eine Schrägansicht eines Teilbereiches der erfindungsgemäßen Anzeige- und/oder Signalisiervorrichtung;
- Fig. 5: eine andere Ausbildung eines Linsenkörpers der erfindungsgemäßen Anzeige-und/oder Signalisiervorrichtung;
- Fig. 6: eine weitere Ausführung eines Linsenkörpers der erfindungsgemäßen Anzeige- und/oder Signalisiervorrichtung;
- Fig. 7: eine andere Ausführung eines Linsenkörpers der erfindungsgemäßen Anzeige- und/oder Signalisiervorrichtung;
- Fig. 8: eine weitere Ausführung eines Linsenkörpers der erfindungsgemäßen Anzeige- und/oder Signalisiervorrichtung;
- Fig. 9: einen Linsenkörper der Linsenanordnung als Detailansicht, geschnitten.

Einführend sei festgehalten, daß in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind bei einer Lageänderung sinngemäß auf die neue Lage zu übertragen. Weiters können auch Einzelmerkmale oder Merkmalskombinationen aus den gezeigten und beschriebenen unterschiedlichen Ausführungsbeispielen für sich eigenständige, erfinderische oder erfindungsgemäße Lösungen darstellen.

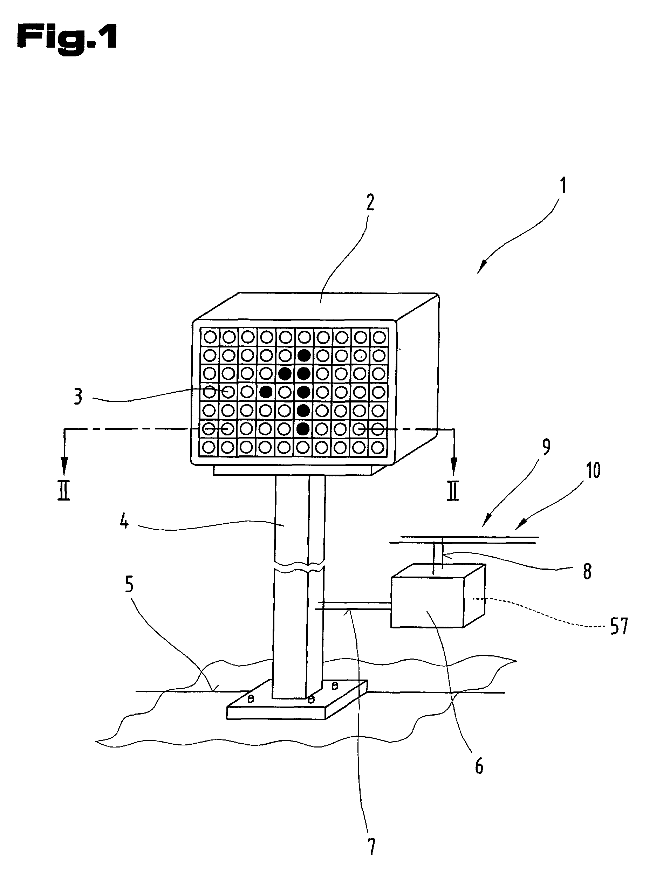

In der Fig. 1 ist eine Anzeige- und/oder Signalisiervorrichtung 1 zur Darstellung lichtoptischer Informationen gezeigt. Bei diesen lichtoptischen Informationen kann es sich zur Abdekkung einer Vielzahl von unterschiedlichen Informationen, wie z.B. für Werbezwecke, Verkehrsleitung etc., in Form von Bild- oder Zeichen- oder Zifferndarstellungen handeln. Die Anzeige- und/oder Signalisiervorrichtung 1 weist z.B. eine in Gehäuseform ausgebildete Anzeigeeinheit 2 auf, in der die erforderlichen lichttechnischen und elektrotechnischen Einrichtungen für den unmittelbaren Betrieb von Lichtquellen 3 angeordnet sind und welches z.B. über eine Standsäule 4 auf einer Aufstandsfläche 5 abgestützt ist. Selbstverständlich sind auch andere, nicht im Detail dargestellte Anbringungsmöglichkeiten der Anzeigeeinheit 2, z.B. an Gebäudewänden, wie auch in Innenräumen von Gebäuden etc., möglich. Die Anzeige- und/oder Signalisiervorrichtung 1 ist beispielsweise mit einer externen Versorgungs- und/oder Steuereinrichtung 6 über Leitungen 7 verbunden, die wiederum über Versorgungsleitungen 8 mit einer Energiequelle 9, z.B. einem Stromnetz 10, verbunden ist. Selbstverständlich sind auch Ausführungen möglich, bei denen die Versorgungs- und/oder Steuereinrichtung im Gehäuse 2 integriert angeordnet ist, wie auch die Versorgung mit Akkus, Solarenergie etc.

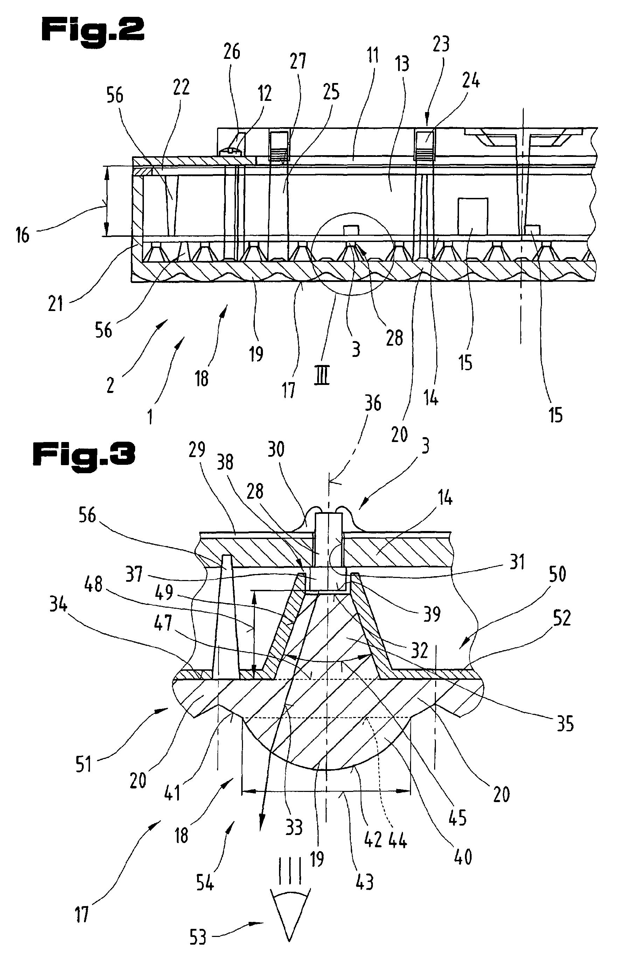

In der Fig. 2 ist nunmehr die Anzeigeeinheit 2 der Anzeige- und/oder Signalisiervorrichtung 1 teilweise geschnitten dargestellt. Auf einer Montageplatte 11 ist über Verbindungsmittel 12, z.B. Schrauben, ein Trägerrahmen 13 befestigt. Auf diesem ist weiters ein plattenförmiges Trägerelement 14 angeordnet, das mit den beispielsweise in einem vorgegebenen Raster angeordneten Lichtquellen 3, z.B. LED's, bestückt ist. Das Trägerelement 14 kann nunmehr als Leiterplatte ausgeführt sein oder lediglich als Montageplatte vorliegen, um die darauf angeordneten Lichtquellen 3 durch Kabel- bzw. Leitungsverbindungen miteinander und mit anderen Bauteilen 15, beispielsweise Bauteile der Elektronik oder Elektrik, zu verbinden. Als Leitungsverbindung eignet sich besonders das "Wire-Wrap-Verfahren". Bei Ausführung des Trägerelementes 14 als Leiterplatte kann dieses einseitig oder beidseitig mit Leiterbahnen versehen, bzw. als "Multilayer" ausgebildet sein. Weiters besteht die Möglichkeit, die Lichtquellen bzw. weiteren Bauteile 15 in "SMD-Technik" auszubilden. Es ist auch möglich, die Lichtquellen 3 durch andere, aus dem Stand der Technik bekannte Lichtquellen 3, wie beispielsweise Glüh- oder Glimmlämpchen, auszuführen. Grundsätzlich wird man trachten, die Lichtquellen 3 derart anzuordnen, daß zwischen ihnen nur ein geringer Abstand besteht und so die Lichtpunkte aus einiger Entfernung betrachtet als einheitliche Zeichen, Symbole wahrzunehmen.

Der Trägerrahmen 13 weist dabei eine Höhe 16 auf, durch die eine entsprechende Distanz zwischen der Montageplatte 11 und dem Trägerelement 14 für die Unterbringung der Bauteile 15 gegeben ist.

Ein Anzeigefeld 17 bildet nunmehr eine den Lichtquellen 3 vorgeordnete, plattenförmig ausgebildete einstückige Linsenanordnung 18, die aus einer dem Raster der Lichtquellen 3 entsprechenden Anordnung von Linsenkörpern 19 gebildet ist, die über Wandbereiche 20 verbunden sind, wobei jeder Lichtquelle 3 ein derartiger Linsenkörper 19 zugeordnet ist. Seitlich wird die Linsenanordnung 18 durch Seitenwände 21 begrenzt, die das Trägerelement 14 und den Trägerrahmen 13 umfassen und unter Zwischenschaltung einer Dichtungsanordnung 22 einen dichten Abschluß zur Montageplatte 11 ausbilden.

Nach einer bevorzugten Ausführungsform zur lösbaren Verbindung der Linsenanordnung 18 mit der Montageplatte 11 sind Verschlußanordnungen 23 in Form von Schnappelementen 24 vorgesehen, die z.B. über Federarme 25 einstückig an der Linsenanordnung 18 angeformt sind und mit hakenförmigen Vorsprüngen 26 zum Einrasten in Gegenaufnahmen 27 der Montageplatte 11 ausgebildet sind.

In der Fig. 3 ist nunmehr ein Detail der Linsenanordnung 18, bestehend aus den über die Wandbereiche 20 verbundenen Linsenkörpern 19, gezeigt. Auf dem Trägerelement 14 sind die Lichtquellen 3, z.B. LED's 28, angeordnet und mit auf dem Trägerelement 14 angeordneten Leiterbahnen 29, z.B. über Kontaktfahnen 30, leitend verbunden und gegebenenfalls über diese in Bohrungen 31 des Trägerelementes 14 gehaltert. Damit bildet das Trägerelement 14 gleichzeitig eine Leiterplatte aus, die eine Montage wesentlich vereinfacht. In Richtung der vom LED 28, insbesondere einer Stirnfläche 32 des LED's 28, abgestrahlten Lichtstrahlen - gemäß Pfeil 33 - ist der Linsenkörper 19 der Linsenanordnung 18 mit einem aus einer Oberfläche 34 der Wandbereiche 20 in Richtung des LED's 28 vorragenden, bevorzugt kegel- oder pyramidenstumpfförmigen Lichtleitfortsatz 35 versehen, der in bezug auf eine Längsmittelachse 36 der Lichtquelle 3 konzentrisch verläuft. Nach einer möglichen Ausführung ist ein Leuchtkopf 37 in einer sacklochförmigen Aufnahme 38 im Lichtleitfortsatz 35 vertieft angeordnet und der Stirnfläche 32 zugewandt eine kreisförmige Lichteintrittsfläche 39 ausgebildet.

Konzentrisch in bezug auf die Längsmittelachse 36 weist der Linsenkörper 19 eine Linsenkuppe 40 auf, welche eine von der Oberfläche 34 entgegengesetzte Oberfläche 41 der Wandbereiche 20 überragt. Die Linsenkuppe 40 bildet dabei eine etwa bis zu den Wandbereichen 20 sich erstreckende räumlich gekrümmte Lichtaustrittsfläche 42 aus. Jedenfalls ist eine lichte Weite 43 einer Basisfläche 44 der Linsenkuppe 40 in Abhängigkeit eines Streuwinkels 45 der von der Lichtquelle 3 ausgestrahlten Lichtstrahlen 33, der sich aus einem vorgegebenen Zentrumswinkel 46 des kegel- oder pyramidenstumpfförmigen Lichtleitfortsatzes 35 ergibt, gebildet. Weiters ist die lichte Weite 43 abhängig von einer Basisfläche 47 des Lichtleitfortsatzes 35, welche etwa in einer durch die Oberfläche 34 gebildeten Ebene verläuft und weiters abhängig von einer darauf senkrecht verlaufenden Distanz 48 zwischen der Basisfläche 47 und der Lichteintrittsfläche 39 ist.

Die Lichtaustrittsfläche 42 kann unterschiedliche Gestaltungsformen aufweisen und ist in bevorzugten Ausführungsbeispielen eine konvex gekrümmte Fläche, durch die entsprechend eines Brechungswinkels der Lichtstrahlen 33 beim Austritt aus dem Material des Linsenkörpers 19 eine in etwa parallele Ausrichtung und damit eine Erhöhung der Leuchtdichte zur Verbesserung der Wahrnehmung auch bereits aus großen Distanzen zu der Anzeige- und/oder Signalisiervorrichtung 1 erreicht wird.

Auf einer durch die Oberfläche 34 der Wandbereiche 20 und einer Hüllfläche 49 der Lichtleitfortsätze 35 gebildeten Rückseite 50 ist die Linsenanordnung 18, die auch als Display 51 bezeichnet werden kann, mit einer Lichtabsorptionsschichte 52 versehen. Diese ist mit dem Material des Display 51 lichtoptisch verbunden und weist einen Absorptionsfaktor von nahe 100% auf. Die Lichtabsorptionsschichte 52 kann durch einen Farbauftrag, insbesondere durch Aufspritzen, Laserbeschichten etc., gebildet sein. Weiters ist es auch möglich, das Display 51 in einem sogenannten 2-K-Kunststoffspritzverfahren herzustellen, wobei in einem Folgespritzverfahren auf das vorgeformte Display 51 eine sich mit diesem thermisch verbindende Kunststoffschichte mit Lichtabsorptionseigenschaften aufgebracht wird. Damit ist eine innige optische Verbindung gegeben, durch die auf diese Lichtabsorptionsschichte 52 auftreffende Lichtstrahlen, insbesondere von Fremdlichtquellen wie Sonne, Scheinwerfer etc. stammende Strahlen unabhängig vom Auftreffwinkel absorbiert werden und jegliche Reflexion, die ein sogenanntes Phantombild bewirken könnten, unterbunden wird. Durch eine besondere Formgebung der Wandbereiche 20 auf einer einem Betrachter 53 zugewandten Vorderseite 54 der Linsenanordnung 18, z.B. einer Ausbildung in Form von Sattelflächen, Schrägflächen etc., werden von dieser eventuell reflektierte Lichtstrahlen in Richtungen abgelenkt, die auf den Betrachter 53 keine störenden Reflexionen ergeben.

Das Material der Linsenanordnung 18 ist bevorzugt aus glasklarem Kunststoff mit einem hohen Lichtdurchgangsfaktor gebildet, wodurch Verluste an Leuchtstärke gering gehalten werden. Es sind aber auch Ausführungen möglich, bei denen das Material der Linsenanordnung transparent färbig ausgebildet ist.

Die Lichtquellen 3 können sowohl einzeln mit Energie beaufschlagt werden, wie es auch steuerungstechnisch möglich ist, diese zu getrennt mit Energie beaufschlagbaren Gruppen mit z.B. unterschiedlicher Leuchtfarbe zusammenzufassen. Damit können optische Informationen wirkungsvoll gestaltet und funktionell dargeboten werden.

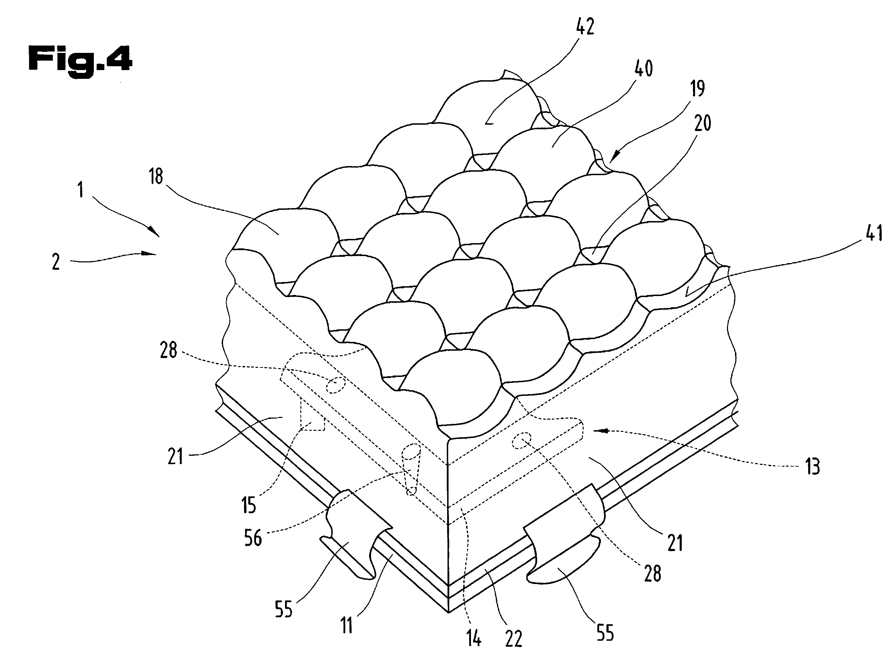

In der Fig. 4 ist ein Detailbereich der Anzeige- und/oder Signalisiervorrichtung 1 gezeigt. Auf der Montageplatte 11 ist über die Dichtungsanordnung 22 die von den Seitenwänden 21 umgrenzte Anzeigeeinheit 2, bestehend aus der Linsenanordnung 18, befestigt. Die Fixierung zwischen der Montageplatte 11 und den Seitenwänden 21 kann, wie beispielhaft gezeigt, über federelastische Halteklammern 55 erfolgen. Damit wird ein staub- und feuchtigkeitsdichter Innenraum für das mit den LED's 28 bestückte Trägerelement 14 und die elektrischen bzw. elektronischen Bauteile 15 erreicht.

Das Anzeigefeld 17 wird im wesentlichen durch die unmittelbare Aneinanderreihung der einstückig über die Wandbereiche 20 miteinander verbundenen Linsenkörper 19 gebildet, die die Wandbereiche 20 bzw. deren Oberfläche 41 mit der die sphärisch gekrümmte Lichtaustrittsfläche 42 ausbildenden Linsenkuppe 40 überragen. Den LED's 28 zugewandt weist die Linsenanordnung 18 die Lichtleitfortsätze 35 mit der Lichteintrittsfläche 39 auf (siehe Fig. 3).

Zwischen der Montageplatte 11 und dem von dieser distanzierten Trägerelement 14 ist zur Distanzhaltung sowie zur Aufnahme weiterer elektrischer bzw. elektronischer Bauteile gegebenenfalls der Trägerrahmen 13 angeordnet bzw. über Befestigungselemente, z.B. Schrauben, auf der Montageplatte 11 befestigt. Durch die Verwendung der Halteklammern 55 ist die Anzeigeeinheit 2 im Bedarfsfall, insbesondere bei Reparaturen und Austausch von elektrischen bzw. elektronischen Bauteilen, oder zur Wartung rasch zu öffnen und können derartige Maßnahmen kurzfristig durchgeführt werden. Zur Positionierung und Distanzierung der Linsenanordnung 18, des Trägerelementes 14 und der Montageplatte 11 sind stiftförmige Distanzelemente 56 vorgesehen.

Die die Linsenkörper 19 verbindenden Wandbereiche 20 sind im gezeigten Ausführungsbeispiel als Sattelflächen mit kontinuierlichen Flächenübergängen zu den Linsenkuppen 40 gebildet, wodurch reflektierte Lichtstrahlen von Fremdlichtquellen großteils aus dem Wahrnehmungsbereich eines Betrachters gelenkt werden und außerdem Ablagerungen von Schmutzpartikel aus der Umgebung der Anzeigeeinheit 2, insbesondere beim Betrieb derselben im Freien, erschwert wird und die Reinhaltung vereinfacht durchzuführen ist.

Im wesentlichen ist die Ausbildung dieser Wandbereiche 20 aber auch in Hinblick auf die Ablenkung etwaiger reflektierter Fremdlichtstrahlen gestaltet, um möglichst keine Lichtreflexe auftreten zu lassen, die z.B. zu einem Phantombild führen könnten oder die Erkennbarkeit der Anzeige vermindern würden.

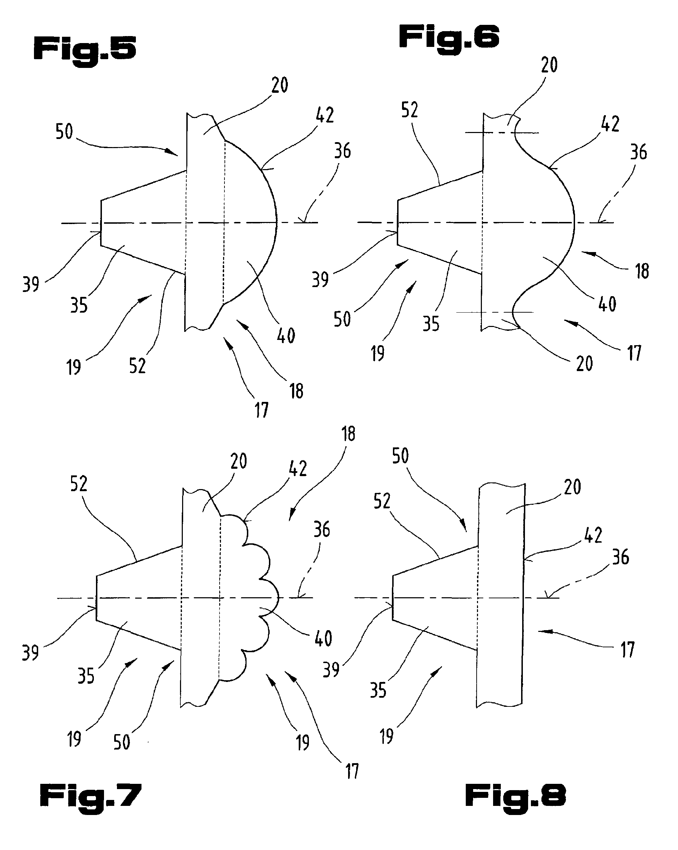

In den Fig. 5 bis 8 sind beispielhaft und in vereinfachter Darstellung mögliche Querschnittsformen der Linsenkörper 19, geschnitten gemäß einer die Längsmittelachse 36 aufnehmenden Ebene, dargestellt. Wie diesen Fig. zu entnehmen, sind unterschiedliche Gestaltungsmöglichkeiten, insbesondere der Linsenkuppen 40, sowie der diese verbindenden Wandbereiche 20 möglich und reichen die Formen der Lichtaustrittsflächen 42 von sphärisch gekrümmten Flächen, Kugelkalotten, Elliptoidflächen, Mehrfachlinsenflächen zur Erzielung besonderer Effekte im Anzeigefeld 17 bis hin zu einer ebenflächigen Ausbildung, welche einen direkten Lichtdurchtritt zuläßt und in Verbindung mit der schwarzen Lichtabsorptionsschichte 52 auf der Rückseite 50 ein schwarzes Erscheinungsbild abgeben, wodurch die die Information wiedergebenden Lichtflächen besonders kontrastreich in Erscheinung treten und Spiegelungen durch Reflexionslichtstrahlen durch den hohen Absorptionsgrad der Lichtabsorptionsschicht 52 nicht oder nur in unbedeutendem Ausmaß auftreten.

Selbstverständlich sei nochmals angemerkt, daß zur Bildung unterschiedlicher Informationen die Lichtquellen 3, insbesondere die LED's 28 (siehe Fig. 3), einzeln, aber auch gruppenweise zu Leuchteinheiten zusammengefaßt werden und einzeln oder in Gruppen mit elektrischer Energie versorgt werden können und gegebenenfalls diese Versorgung über eine Steuereinrichtung 57 (siehe Fig. 1), z.B. einer frei programmierbaren Steuerung, integrierten Schaltkreis etc., angesteuert werden kann, um z.B. rasch wechselnde Informationsinhalte am Anzeigefeld 17 erscheinen zu lassen. Damit sind sogenannte Lauflicht-Werbeinformationen, wechselnde Graphiken etc. darstellbar.

Es soll aber auch darauf hingewiesen werden, daß die Leuchtfarbe der LED's 28 unterschiedlich sein kann, um bei Verwendung einer glasklaren Linsenanordnung 18 die gewünschte Signal- oder Informationsleuchtfarbe zu erreichen, da in verschiedenen Anwendungsfällen der Leuchtfarbe eine ganz bestimmte Bedeutung zukommt, z.B. Rotlicht für "Halt" oder Grünlicht für "Frei".

Eine weitere Möglichkeit zur vielseitigen Anwendung der Anzeige- und/oder Signalisiervorrichtung 1 besteht auch in einer transparent färbigen Ausbildung der Linsenanordnung 18, um einen gewünschten Farbton zu verstärken oder zu erreichen.

Es können weiters Funktionsgruppen aus LED's 28 bzw. Linsenkörper 19 im Anzeigefeld 17 gebildet werden, wobei diese z.B. aus einer Anzahl von eine unterschiedliche Leuchtfarbe abgebenden LED's 28 gebildet werden.

Es sei auch erwähnt, daß mehrere der einstückig ausgebildeten Linsenanordnungen 18 zur Erzielung eines größeren, aber auch von der reinen quadratischen oder rechteckigen Form abweichenden Anzeigefeld 17 in einer beliebigen Anzahl und Form aneinandergereiht werden können. Für eine derartige Ausbildung ist es zweckmäßig, die Außenabmessungen der Linsenanordnung 18 unter Einbeziehung der Seitenwände 21 auf ein gewünschtes Rastermaß abzustimmen. Damit entsteht bei einer Aneinanderreihung derartiger Linsenanordnungen 18 wieder der Eindruck einer einstückigen Ausbildung und eines einheitlichen Anzeigefeldes 17.

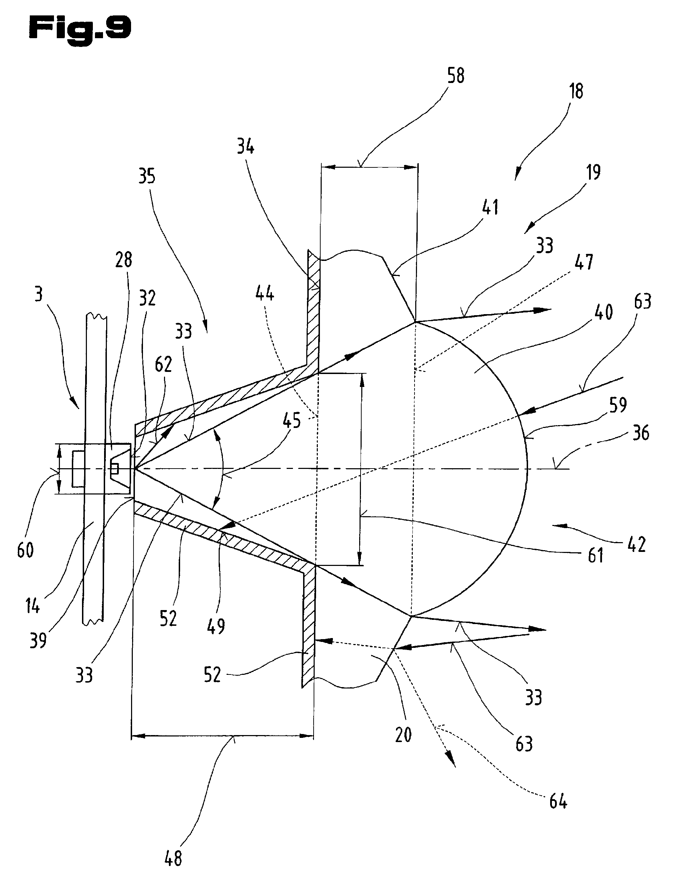

In der Fig. 9 ist nun noch im Detail ein Linsenkörper 19 der Linsenanordnung 18 geschnitten dargestellt. Im gezeigten Beispiel wird der Linsenkörper 19 durch den der Lichtquelle 3, insbesondere dem LED 28, zugewandten kegelstumpfförmigen Lichtleitfortsatz 35 und der über eine Dicke 58 der umgebenden Wandbereiche 20 distanzierten Linsenkuppe 40 gebildet. Auf der der Lichtquelle 3 zugewandten Oberfläche 34 der Wandbereiche 20 sowie der Hüllfläche 49 des Lichtleitfortsatzes 35 ist die Lichtabsorptionsschicht 52 z.B. durch Auftrag einer schwarzen Farbschicht angeordnet. Der Lichtquelle 3 bzw. deren Stirnfläche 32 ist die Lichteintrittsfläche 39 des Lichtleitfortsatzes 35 zugewandt. Die Lichtaustrittsfläche 42 wird durch eine Oberfläche 59 der Linsenkuppe 40 gebildet, die gegenüber der Lichteintrittsfläche 39 einen konkaven Verlauf aufweist, aber in bezug auf die Längsmittelachse 36 rotationssymmetrisch wie auch asymmetrisch ausgebildet sein kann, wodurch die Lichtstrahlenverteilung wunschgemäß ausgestaltet werden kann. Die Oberflächen 41 der Wandbereiche 20 sind z.B. kontinuierlich gekrümmt, winkelig geneigt, in Form von Sattelflächen etc. ausgebildet.

Die weitere Beschreibung geht nunmehr der Einfachheit wegen von einer punktförmigen Lichtquelle aus und ist diese sinngemäß auf eine gemäß einem Durchmesser 60 des Leuchtkopfes 37 sich ergebende kreisförmige Abgabefläche der ausgesendeten Lichtstrahlen - Pfeil 33 - zu übertragen. Der Streuwinkel 45 ergibt sich aus einem Durchmesser 61 der Basisfläche 44 und der Distanz 48 dieser von der Lichteintrittsfläche 39. Lichtstrahlen - gemäß Pfeil 62 - mit größerem Streuwinkel treffen in der Hüllfläche 49 auf die Lichtabsorptionsschicht 52 und werden von dieser zur Vermeidung von die Linsenanordnung 18 verlassenden, die Wahrnehmbarkeit der Informationen negativ beeinflussenden Reflexionslichtstrahlen absorbiert.

Die Basisfläche 47 der Linsenkuppe 40 ist entsprechend dem sich aus Streuwinkel 45 und Dicke 58 ergebenden Winkelverhältnis vergrößert, wodurch sämtliche aus dem Lichtleitfortsatz 35 austretenden Lichtstrahlen - gemäß Pfeil 33 - über die Oberfläche 59 der Linsenkuppe 40 verteilt auftreffen und entsprechend der Krümmung und dem Brechungswinkel in Richtung eines Betrachters gerichtet werden, um den Verlust durch Streulicht gering zu halten.

Auf die Oberfläche 59 der Linsenkuppe 40 bzw. Oberfläche 41 der Wandbereiche 20 auftreffende Fremdlichtstrahlen - gemäß Pfeil 63 - werden bei Durchgang durch den Linsenkörper 19 von der Lichtabsorptionsschicht 52 absorbiert bzw. Reflexionsstrahlen - gemäß Pfeil 64 - in einen Bereich reflektiert, der außerhalb des Beobachtungsbereiches liegt, wodurch eine Beeinträchtigung in der Wahrnehmung der Informationen sowie Phantombilderscheinungen ausbleiben.

Diese Verhältnisse treffen sinngemäß natürlich auch auf die weiteren, in den Fig. 5 bis 8 dargestellten Linsenkörper 19 zu.

Der Ordnung halber sei abschließend darauf hingewiesen, daß zum besseren Verständnis der Anzeige- und/oder Signalisiervorrichtung 1 diese bzw. deren Bestandteile teilweise unmaßstäblich und/oder vergrößert und/oder verkleinert dargestellt wurden.

Die den eigenständigen erfinderischen Lösungen zugrundeliegende Aufgabe kann der Beschreibung entnommen werden.

Vor allem können die einzelnen in den Fig. 1; 2; 3; 4; 5, 6, 7, 8; 9 gezeigten Ausführungen und Maßnahmen den Gegenstand von eigenständigen, erfindungsgemäßen Lösungen bilden. Die diesbezüglichen, erfindungsgemäßen Aufgaben und Lösungen sind den Detailbeschreibungen dieser Figuren zu entnehmen.

### Bezugszeichenaufstellung

- 1: Anzeige- und/oder Signalisiervorrichtung
- 2: Anzeigeeinheit
- 3: Lichtquelle
- 4: Standsäule
- 5: Aufstandsfläche

- 6: Versorgungs- und/oder Steuereinrichtung
- 7: Leitung
- 8: Leitung
- 9: Energiequelle
- 10: Stromnetz

- 11: Montageplatte
- 12: Verbindungsmittel
- 13: Trägerrahmen
- 14: Trägerelement
- 15: Bauteil

- 16: Höhe
- 17: Anzeigefeld
- 18: Linsenanordnung
- 19: Linsenkörper
- 20: Wandbereiche

- 21: Seitenwände
- 22: Dichtungsanordnung
- 23: Verschlußanordnung
- 24: Schnappelement
- 25: Federarm

- 26: Vorsprung
- 27: Gegenaufnahme
- 28: LED
- 29: Leiterbahn
- 30: Kontaktfahne

- 31: Bohrung
- 32: Stirnfläche
- 33: Pfeil
- 34: Oberfläche
- 35: Lichtleitfortsatz

- 36: Längsmittelachse
- 37: Leuchtkopf
- 38: Aufnahme
- 39: Lichteintrittsfläche
- 40: Linsenkuppe

- 41: Oberfläche
- 42: Lichtaustrittsfläche
- 43: Weite
- 44: Basisfläche
- 45: Streuwinkel

- 46: Zentrumswinkel
- 47: Basisfläche
- 48: Distanz
- 49: Hüllfläche
- 50: Rückseite

- 51: Display
- 52: Lichtabsorptionsschicht
- 53: Betrachter
- 54: Vorderseite
- 55: Halteklammer

- 56: Distanzelement
- 57: Steuereinrichtung
- 58: Dicke
- 59: Oberfläche
- 60: Durchmesser

- 61: Durchmesser
- 62: Pfeil
- 63: Pfeil
- 64: Pfeil

## Patentansprüche

1. Anzeige- und/oder Signalisiervorrichtung für lichtoptische Informationen mit auf einer Trägerplatte oder Gehäuseteil angeordneten Lichtquellen, insbesondere LED's, und mit Mittel zu deren Energieversorgung und mit einer den Lichtquellen vorgesetzten Linsenanordnung, **dadurch gekennzeichnet, daß** die Linsenanordnung (18) ein einstückiges, flächiges Anzeigefeld (17) mit einer Mehrzahl von über Wandbereiche (20) verbundenen Linsenkörpern (19) ausbildet und auf einer den Lichtquellen (3) zugewandten Oberfläche (34) eine durch Lichteintrittsflächen (39) unterbrochene Lichtabsorptionsschicht (52) angeordnet ist.

2. Anzeige- und/oder Signalisiervorrichtung nach Anspruch 1, **dadurch gekennzeichnet. daß** auf der Oberfläche (34) den Lichtquellen (3) zugeordnet die Oberfläche (34) überragend Lichtleitfortsätze (35) angeordnet sind und etwa parallel zur Oberfläche (34) verlaufende Stirnflächen (32) der Lichtleitfortsätze (35) die Lichteintrittsfläche (39) ausbilden.

3. Anzeige- und/oder Signalisiervorrichtung nach Anspruch 1 oder 2, **dadurch gekennzeichnet, daß** konzentrisch zu den Lichteintrittsflächen (39) auf einer zu der die Lichtleitfortsätze (35) aufweisenden Oberfläche (34) entgegengesetzten Oberfläche (41) der Wandbereiche (20) diese überragende Linsenkuppen (40) der Linsenkörper (10) angeordnet sind.

4. Anzeige- und/oder Signalisiervorrichtung nach einem oder mehreren der vorhergehenden Ansprüche, **dadurch gekennzeichnet, daß** die Linsenkuppe (40) eine konvex gekrümmte Lichtaustrittsfläche (42) ausbildet.

5. Anzeige- und/der Signalisiervorrichtung nach einem oder mehreren der vorhergehenden Ansprüche, **dadurch gekennzeichnet, daß** Seitenflächen des Lichtleitfortsatzes (35) eine mit zunehmender Distanz (48) von der Oberfläche (34) auf die Lichteintrittsfläche (39) hin konvergierend verlaufende Hüllfläche (49) ausbilden.

6. Anzeige und/oder Signalisiervorrichtung nach einem oder mehreren der vorhergehenden Ansprüche, **dadurch gekennzeichnet, daß** eine etwa in einer Ebene der Oberfläche (34) verlaufende Basisfläche (47) des Lichtleitfortsatzes (35) einen Streuwinkel (45) begrenzt.

7. Anzeige und/oder Signalisiervorrichtung nach einem oder mehreren der vorhergehenden Ansprüche, **dadurch gekennzeichnet, daß** der Lichtleitfortsatz (35) durch einen Kegeloder Pyramidenstumpf mit kreisrunder oder mehreckiger Basisfläche (47) gebildet ist.

8. Anzeige- und/oder Signalisiervorrichtung nach einem oder mehreren der vorhergehenden Ansprüche, **dadurch gekennzeichnet, daß** die Lichteintrittsfläche (39) durch eine etwa parallel zur Oberfläche (34) und von dieser distanzierten Stirnfläche (32) des Lichtleitfortsatzes (35) gebildet ist.

9. Anzeige- und/oder Signalisiervorrichtung nach einem oder mehreren der vorhergehenden Ansprüche, **dadurch gekennzeichnet, daß** in der Stirnfläche (32) eine vertiefte Aufnahme (38) zur in bezug auf die Linsenkörper (19) positionsgenauen Aufnahme der Lichtquelle (3) bzw. eines Leuchtkopfes (37) angeordnet ist.

10. Anzeige- und/oder Signalisiervorrichtung nach einem oder mehreren der vorhergehenden Ansprüche, **dadurch gekennzeichnet, daß** eine etwa fluchtend zu der Oberfläche (41) verlaufende Basisfläche (44)-der Linsenkuppe (40) mindestens eine solche Größe aufweist, daß alle den Streuwinkel (45) begrenzenden Lichtstrahlen durch sie hindurchgehen.

11. Anzeige- und/oder Signalisiervorrichtung nach einem oder mehreren der vorhergehenden Ansprüche, **dadurch gekennzeichnet, daß** die Hüllfläche (49) der Lichtleitfortsätze (35) und die Hüllflächen (49) verbindende Oberflächenbereiche der Wandbereiche (20) mit der Lichtabsorptionsschicht (52) versehen sind.

12. Anzeige- und/oder Signalisiervorrichtung nach einem oder mehreren der vorhergehenden Ansprüche, **dadurch gekennzeichnet, daß** die Lichtabsorptionsschicht (52) mit dem Material der Linsenanordnung (18) thermisch verbunden, insbesondere auf dieses aufgespritzt, ist.

13. Anzeige- und/oder Signalisiervorrichtung nach einem oder mehreren der vorhergehenden Ansprüche, **dadurch gekennzeichnet, daß** die Lichtabsorptionsschicht (52) auf dem Material der Linsenanordnung (18) durch einen Farbauftrag, z.B. durch Spritzen, aufgebracht ist.

14. Anzeige- und/oder Signalisiervorrichtung nach einem oder mehreren der vorhergehenden Ansprüche, **dadurch gekennzeichnet, daß** die Lichtabsorptionsschicht (52) durch Laser-Spritzverfahren auf dem Material der Linsenanordnung (18) aufgebracht ist.

15. Anzeige- und/oder Signalisiervorrichtung nach einem oder mehreren der vorhergehenden Ansprüche, **dadurch gekennzeichnet, daß** ein Lichtabsorptionsgrad der Lichtabsorptionsschicht (52) nahe 100% ist und tiefschwarz erscheint.

16. Anzeige- und/oder Signalisiervorrichtung nach einem oder mehreren der vorhergehenden Ansprüche, **dadurch gekennzeichnet, daß** das Material der Linsenanordnung (18) bevorzugt ein Kunststoffmaterial, insbesondere PMMA oder PC - PolymethylMethacrylat oder Polycarbonat -, ist.

17. Anzeige- und/oder Signalisiervorrichtung nach einem oder mehreren der vorhergehenden Ansprüche, **dadurch gekennzeichnet, daß** das Material der Linsenanordnung (18) glasklar oder transparent färbig ist.

18. Anzeige- und/oder Signalisiervorrichtung nach einem oder mehreren der vorhergehenden Ansprüche, **dadurch gekennzeichnet, daß** eine die Lichtaustrittsfläche (42) ausbildende Oberfläche (41) der Linsenkuppe (40) durch eine zur Erzielung einer symmetrischen oder asymmetrischen Lichtverteilung gestaltete Freiformfläche gebildet ist.

19. Anzeige- und/oder Signalisiervorrichtung nach einem oder mehreren der vorhergehenden Ansprüche, **dadurch gekennzeichnet, daß** die Oberflächenbereiche der Wandbereiche (20) in Form von Sattelflächen ausgebildet sind.

20. Anzeige- und/oder Signalisiervorrichtung nach einem oder mehreren der vorhergehenden Ansprüche, **dadurch gekennzeichnet, daß** die Linsenanordnung (18) durch zu der durch die Wandbereiche (20) gebildeten Ebene senkrecht ausgerichtete Seitenwände (21) begrenzt ist.

21. Anzeige- und/oder Signalisiervorrichtung nach einem oder mehreren der vorhergehenden Ansprüche, **dadurch gekennzeichnet, daß** das die Lichtquellen (3) aufnehmende Trägerelement (14) gegenüber der Linsenanordnung (18) positionsgenau lagefixiert ist.

22. Anzeige- und/oder Signalisiervorrichtung nach einem oder mehreren der vorhergehenden Ansprüche, **dadurch gekennzeichnet, daß** das Trägerelement (14) über bevorzugt mehrere Distanzelemente (56) gegenüber der Linsenanordnung (18) und dem Trägerrahmen (13) und oder der Montageplatte (11) und diese über Befestigungsmittel, z.B. Schnappelemente (24), miteinander verbunden sind.

23. Anzeige- und/oder Signalisiervorrichtung nach einem oder mehreren der vorhergehenden Ansprüche, **dadurch gekennzeichnet, daß** zwischen Stirnflächen der Seitenwände (21) der Linsenanordnung (18) und der Montageplatte (11) eine Dichtungsanordnung (22) vorgesehen ist.

24. Anzeige- und/oder Signalisiervorrichtung nach einem oder mehreren der vorhergehenden Ansprüche, **dadurch gekennzeichnet, daß** das Trägerelement (14) als Leiterplatte ausgebildet ist.

25. Anzeige- und/oder Signalisiervorrichtung nach einem oder mehreren der vorhergehenden Ansprüche, **dadurch gekennzeichnet, daß** das Trägerelement (14) mit LED's (28) gleicher oder unterschiedlicher Leuchtfarbe bestückt ist.

26. Anzeige- und/oder Signalisiervorrichtung nach einem oder mehreren der vorhergehenden Ansprüche, **dadurch gekennzeichnet, daß** die Lichtquellen (3) schaltungstechnisch zu leitungsverbundene Funktionsgruppen zusammengefaßt sind.

27. Anzeige- und/oder Signalisiervorrichtung nach einem oder mehreren der vorhergehenden Ansprüche, **dadurch gekennzeichnet, daß** die Funktionsgruppen durch LED's (28) gleicher oder unterschiedlicher Leuchtfarbe gebildet sind.

28. Anzeige- und/oder Signalisiervorrichtung nach einem oder mehreren der vorhergehenden Ansprüche, **dadurch gekennzeichnet, daß** eine Steuereinrichtung (57) für die Lichtquellen (3) bzw. die aus den Lichtquellen (3) gebildeten Funktionsgruppen durch eine IC-Schaltung, oder einen Personalcomputer etc. gebildet ist, welche bzw. welcher mit der Versorgungs- und/oder Steuereinrichtung (6) leitungsverbunden ist.

29. Anzeige- und/oder Signalisiervorrichtung nach einem oder mehreren der vorhergehenden Ansprüche, **dadurch gekennzeichnet, daß** die Anzeigeeinheit (2) zur Erzielung beliebig großer Anzeigefelder (17) aus einer Aneinanderreihung mehrerer gleichartiger Linsenanordnungen (18) gebildet ist, wobei eine Außenabmessung jeder Linsenanordnung (18) einem Rastermaß entspricht.
